# EUROPEAN PATENT SPECIFICATION

(11) **EP 3 146 529 B1**
(45) Date of publication and mention of the grant of the patent: **23.10.2019**
(21) Application number: 15795638.4
(22) Date of filing: 18.05.2015
(51) Int. Cl.: H01B 1/22, H01L 31/0224, H01L 31/068

(54) **A SILVER PASTE CONTAINING BISMUTH OXIDE AND ITS USE IN SOLAR CELLS**
SILBERPASTE MIT BISMUTOXID UND DEREN VERWENDUNG IN SOLARZELLEN
PÂTE D'ARGENT CONTENANT DE L'OXYDE DE BISMUTH ET SON UTILISATION DANS DES CELLULES SOLAIRES

(30) Priority: 19.05.2014 US 201462000141 P
(43) Date of publication of application: 29.03.2017
(73) Proprietor: Sun Chemical Corporation, Parsippany, NJ 07054 (US)
(72) Inventor: SUN, Bo, Bardonia, NY 10954 (US); HE, Jin-An, Mountain Lakes, NJ 07046 (US)
(74) Representative: Carpmaels & Ransford LLP
(86) International application number: PCT/US2015/031319
(87) International publication number: WO 2015/179268

(56) References cited:
- WO-A1-2009/145386
- WO-A1-2012/031078
- CN-A- 102 543 252
- CN-A- 103 258 584
- CN-B- 102 673 131
- US-A1- 2009 266 409

## Description

This application claims priority to U.S. Provisional Patent Application Serial No. 62/000,141 filed May 19th, 2014.

### FIELD OF THE INVENTION

The present invention is directed to a silver paste for a silicon (Si) solar cell comprising a high purity Bi₂O₃ additive and a solar cell having a silicon wafer with the silver paste on its front-side surface. The solar cell exhibits improved efficiency resulting from the use of the high purity additive in the paste.

### BACKGROUND TO THE INVENTION

Silicon solar cells are extensively used in the rapidly growing photovoltaic (PV) industry.

Silicon solar cells typically include a silicon wafer with a silver (Ag) paste screen-printed with a pattern on the front-side (facing the sunlight) of the silicon wafer. The silicon wafer also typically has two overlapping layers containing aluminum and silver respectively printed on the opposite (back-side) of the silicon wafer.

US 5,066,621 and US 5,336,644 are directed to sealing glass compositions containing metal oxides.

US 2013/0037761 is directed to an electroconductive thick film paste comprising Ag for use in an electrode for a solar cell.

US 2012/0171810 describes paste compositions for an electrode of a solar cell which contains a conductive powder, an organic vehicle and glass frits.

US 2012/0138142 is directed to lead-free and cadmium free paste compositions for use on contacts for solar cells.

US 2010/0294360 and US 2010/0294361 are directed to a process of forming a front-grid electrode on a silicon wafer which printed and dried metal pastes containing glass frits thereon.

US 2012/0312368 and US 2012/173875 describe an electroconductive thick film paste comprising Ag and Pb free bismuth based oxide both dispersed in an organic medium for the use in the manufacture of semiconductor devices.

US 2011/0147677 is directed to zinc containing glass compositions for use in conductive pastes for silicon semiconductor devices and photovoltaic cells.

WO 2012/135551 describes high aspect ratio screen printable thick film paste wax compositions for positioning conductive lines on a solar cell device.

Finally Journal Article: Development of lead-free silver ink for front contact metallization Author(s): Kalio, A.; Leibinger, M.; Filipovic, A.; Kruger, K.; Glatthaar, M.; Wilde, J. is directed to solar energy materials and solar cells.

### SUMMARY OF THE INVENTION

The present invention provides a composition for silicon solar cells comprising a silver powder, glass frits, at least one organic resin, at least one solvent and between 0.1-0.5 wt% of a Bi₂O₃ additive wherein the Bi₂O₃ has an average particle size of between 20 to 300 nm and wherein the additive contains greater than 99.0 wt% Bi₂O₃.

The present invention also provides a solar cell comprising a silicon wafer and the composition on the front side surface of the silicon wafer.

Finally the present invention provides a process for making a solar cell comprising applying a coating of the composition onto the front side surface of a silicon wafer and firing the silicon coated wafer.

These and other objects, advantages, and features of the invention will become apparent to those persons skilled in the art upon reading the details of the methods and formulations as more fully described below.

### DETAILED DESCRIPTION

It has been found that the use of silver paste compositions with a high purity Bi₂O₃ additive in a particular weight range and having a particular particle size results in the production of solar cells with a higher cell efficiency and thus greater power output when exposed to sunlight.

Typically glass frits are added to the silver paste compositions when used in the production of solar cells to etch through the anti-reflective coating (ARC) on the front-side of a silicon wafer.

Furthermore, the use of glass frits also increases the uniformity of the compositions which potentially increases ribbon adhesion and helps to prevent spotty areas caused by the surge in one metal oxide concentration.

However, acceptable uniformity can also be achieved by incorporating metal oxides separately as additives directly into the silver paste compositions.

It has now been found that a high purity Bi₂O₃ additive imparts particularly advantageous properties to high efficiency front-side silver paste compositions. Furthermore it has also been found that Bi₂O₃ with a particular particle size, used as an additive separately or as an additive incorporated into a glass frit, imparts higher efficiency into the front-side silver paste compositions.

By the use of the term "high purity", it is meant that bismuth oxide is essentially the only metal oxide in the additive and while it is possible to use a bismuth oxide additive in conjunction with other metal oxides, the bismuth additive is incorporated alone and not as a multi-component metal oxide mixture.

The Bi₂O₃ additive contains greater than 99.0 wt% such as 99.999 wt%.

The composition comprises between 0.1-0.5 wt% Bi₂O₃ additive based on the total weight of the composition.

The average particle size of the Bi₂O₃ additive is between 20nm to 300nm.

Typically the Ag powder has a purity of greater than 99.5% and usually contains impurities such as Zr, Al, Fe, Na, Zn, Pb at advantageously less than 100ppm.

Typically the composition contains between 70 to 95 wt% of Ag powder, and more preferably between 80 to 92 wt%.

The Ag powder(s) may consist of one or more Ag powder(s) preferably with a particle size D50 between 0.1 to 5µm, more preferably 0.5 to 2 µm.

Usually when two or more Ag powders are used a higher Ag particle packing density is achieved and the proximity of the Ag particles facilitates Ag sintering and percolation during the firing process. This results in a more connected and condensed electron conduction path which generally improves the solar cell efficiency.

The Ag powder(s) are not limited in morphology and may be spherical, elliptical, etc. and typically could be thermally sintered to form a conductive network during the solar cell metallization firing step.

Furthermore the Ag powder(s) may be pre-coated with different surfactants to avoid particle agglomeration and aggregation. The surfactant is advantageously a straight-chain, or branched-chain fatty acid, a fatty acid ester, fatty amide or a mixture thereof.

Additionally long-chain alcohols may also be used for rheology modification.

The composition usually comprises between 0.5 to 10 wt% of glass frits.

The glass frits may be formed from the group consisting of PbO, Al₂O₃, SiO₂, B₂O₃, Li₂O, TiO₂, ZnO, P₂O₅, V₂O₅, SrO, CaO, Sb₂O₃, SO₂, AS₂O₃, Bi₂O₃, Tl₂O₃, Ga₂O₃, MgO, Y₂O₃, ZrO₂, Mn₂O₅, CoO, NiO, CuO, SrO, MO₂O₃, RuO₂, TeO₂, CdO, In₂O₃, SnO₂, La₂O₃, BaO and mixtures thereof.

Additionally, the composition preferably contains between 0.2 to 2 wt% of organic resin and more preferably between 0.5 to 1.5 wt%.

Typically the resin is selected from acrylic resin, epoxy resin, phenol resin, alkyd resin, cellulose polymers, polyvinyl alcohol, rosin and mixtures thereof.

Advantageously the resins should burn off during the firing of the coated silicon wafer such that no residue remains thereon.

Additionally, the composition preferably contains between 0.2 to 20 wt% of solvent and more preferably between 2 to 8 wt%.

Typical solvents include texanol, propanol, isopropyl alcohol, ethylene glycol and diethylene glycol derivatives (glycol ether solvents), toluene, xylene, dibutyl carbitol, terpineol and mixtures thereof.

The solvent is effective for dissolving the resins, rosins, and thixotropic agents and is preferably capable of sustaining paste printing whilst subsequently evaporating thoroughly during the drying step.

The composition also typically contains an adhesion promoting agent, a thixotropic agent and/or a dispersant.

Usually the composition contains between 0.1 to 0.7 wt% of an adhesion promoting agent, between 0.01 to 3.0 wt% of a dispersant and between 0.1 to 2.0 and advantageously between 0.5 to 1.5 wt% of a thixotropic agent.

Typically the thixotropic agent is a cellulose polymer such as ethyl cellulose, hydroxyethyl cellulose, castor oil, hydrogenated castor oil, an amide modified castor oil derivative or a fatty amide. Suitable thixotropic agents include Thixatrol Max, Thixatrol ST and Thixatrol Pro.

Usually the dispersant is long-chain fatty acid such as stearic acid with functional amine, acid ester or alcohol groups. Suitable dispersants include BYK 108, BYK 111, Solsperse 66000 and Solsperse 27000.

The composition is usually in the form of paste and preferably has a viscosity of between 50 to 250Pa·S at 10 recipocal second.

The present invention also provides a process for making a solar cell which involves applying a coating of the composition onto the front side surface of a silicon wafer. Furthermore the process usually involves applying two overlapping layers containing aluminum and silver respectively to the back side surface of the silicon wafer. The coated silicon wafer is then fired.

The composition is usually deposited on a silicon wafer by screen/stencil printing. The stroke movement across the screen provides high shear rate to the composition through micro-channels of mesh pattern. The size of micro-channels is preferably 40 to 80microns for fingers, and preferably 1.0 to 2.0mm for bus bars. The fingers are preferably narrower in order to leave more open area for sunlight collection whilst the bus bars are preferably dashed rather than continuous due to the cost of Ag. The thickness of the printed finger lines is typically between 10 to 35microns. Advantageously the higher the printed fingers the better the finger's conductivity.

The manufacturing of silicon solar cells typically includes several steps namely;
1) the transfer of SiO₂ into a Si ingot;
2) the transfer of the Si ingot to the Si wafer by sawing, etching, doping, ARC and other surface-treatments;
3) screen-printing and drying the back side silver (Ag) paste on the back side of the wafer;
4) screen-printing and drying aluminum (Al) paste on the back side of the wafer;
5) screen-printing and drying the front side silver (Ag) paste on the front side of the wafer;
6) co-firing the coated wafer in a furnace wherein the wafer goes through a temperature curve optimized for the overall efficiency of the device.

Thus the Al and Ag metals in the two back side coatings form a physical contact with the Si wafer through penetrating SiO₂ on the back side. Furthermore they also form a contact with each other through the overlapping area. The front side Ag paste penetrates the anti-reflection layer and reaches n-type Si beneath it and a good ohmic contact is formed between Ag lines and the n-Si emmiter during the firing process. The contact resistance between the Ag lines and the emitter for the current flow is preferred to be minimal to maximize the efficiency of the device. In general, a thin layer of glass frits between the emitter and Ag traces is also preferred and results in higher efficiency.

The invention is further described by the examples given below.

### EXAMPLES

The following examples illustrate specific aspects of the present invention and are not intended to limit the scope thereof in any respect and should not be so construed.

### Example 1 Procedure for making Ag paste.

### Step 1

The varnish in Table 1 was made by dissolving rosin(s) and thixotropic agent(s) in a solvent (ingredients 1-3). The varnish is a mixture of solvent, thixotropic polymer, resins such as ethylene cellulose, polycarbonate, and rosin such as ester of hydrogenated rosin and hydrogenated castor oil. These can immerse glass frit(s), Ag powders and other solids, and make the paste fluidic enough to be capable of going through stainless-steel-mesh/emulsion channels with 30-100micron in channel width, 30-55micron in mesh thickness and 10-30micron in emulsion thickness, forming paste finger lines on the wafer. However, the varnish preferably allows the printed finger lines to have a thixotropy suitable to minimize the paste from spreading, thus more area is left for capturing sunlight to convert to electricity.

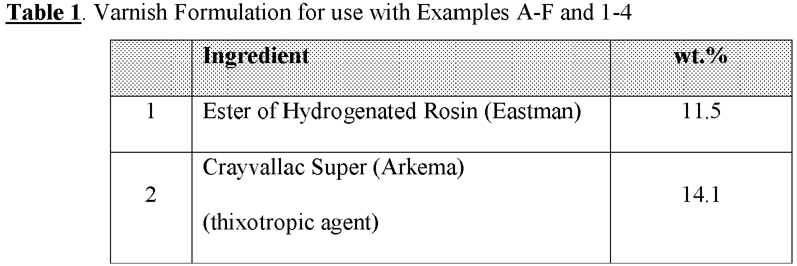

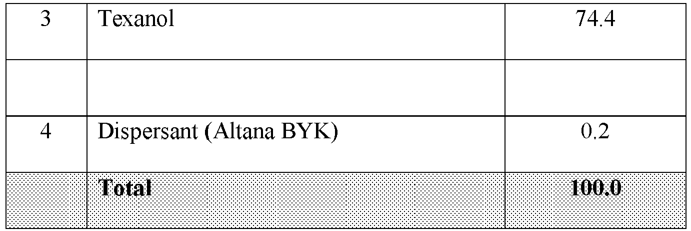

### Step 2

The dispersant (ingredient 4) is then added into the above mixture and was aggressively mixed until it became uniform.

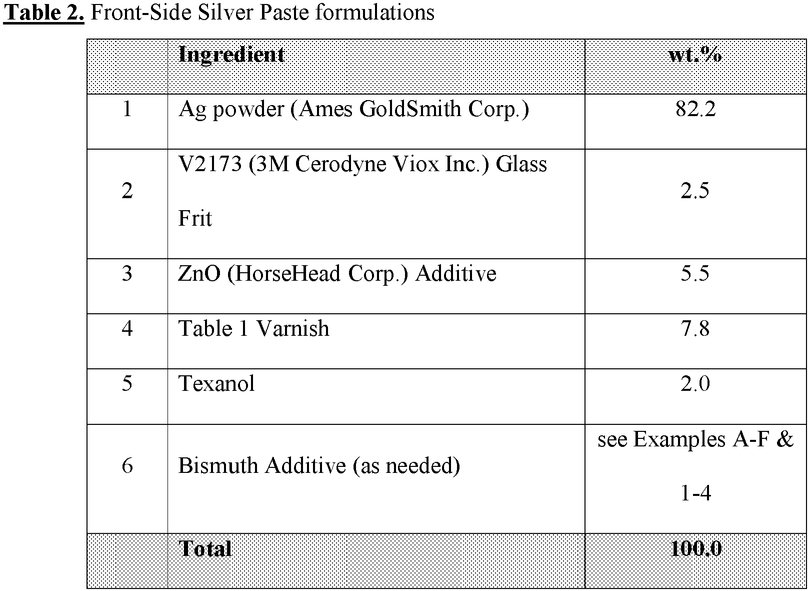

### Step 3

The mixture from step (2) was aggressively mixed with glass frit(s), solvent and additives, including bismuth additives as needed (Table 2 - ingredients 2, 3, 4, 5, 6). The glass frits are commercially available lead borosilicate from 3M Cerodyne Viox Inc. and a typical frit such as V2173, V2172, V0981 may be used alone or as the mixture of in the final paste.

### Step 4

Ag powder(s) (ingredient 1) was then added to the step (3) mixture and mixed aggressively with DAC speed mixer from FlackTek Inc.

### Step 5

The mixture from step (4) is then triple-roll milled to a preferred grind of 6-9µm. The preferred viscosity of the resulting pastes at 10/s is 50-250Pa^{∗}s, more preferably 70-150Pa^{∗}s as measured on AR-2000EX rheometer from TA Instruments.

The three main requirements of the paste are 1) electrical performance, mainly efficiency; 2) green strength (i.e. the lines will hold their integrity and will be resistant to smear during a finger rub test after drying and before firing; 3) ribbon adhesion after firing.

It has been found that Bi₂O₃ powder with an average particle size of 10nm to 3µm can increase the efficiency of the paste. The following experiments using Bi₂O₃ of differing particle size show that the above range is the most advantageous for improving silver paste efficiency.

### Solar cell fabrication and test performance for pastes:

A 5 inch mono-crystalline wafer with an emitter sheet resistance of 80 to 90 Ohm/square are used in this test and 3 steps as described below are used for preparation: 1) 1.0g of A1 paste is screen-printed on the back-side of each Si wafers, it is then dried using BTU International D914 dryer with the setting of belt speed = 90ipm, 310°C (Zone 1), 290°C (Zone 2), and 285°C (Zone 3). The screen used for printing is 325mesh, 23micron wire diameter, and 10micron emulsion, 45 degree bias, the squeegee used is 65-75 shore in hardness; 2) the front-side Ag paste is screen-printed on the front surface of the same wafer and it is dried in the same drying furnace with the setting of belt speed = 165ipm, 340°C (Zone 1), 370°C (Zone 2), and 370°C (Zone 3). The screen used for printing is 325mesh, 23micron wire diameter, and 16micron emulsion, 22.5 degree bias, the squeegee used is 65-75 shore in hardness; 3) the wafers are fired using BTU International PV309 firing furnace with the setting of belt speed belt speed = 200ipm, 850°C (Zone 1), 790°C (Zone 2), 790°C (Zone 3), and 1000°C (Zone 4). The electrical performance (open-circuit voltage Voc (V), efficiency, fill factor, series resistance and shunt resistance in the dark and under light) is measured using a Solar Simulator/I-V tester from PV Measurements Inc. The illumination of the lamp was calibrated using a sealed calibration cell, and the measured characteristics were adjusted to the standard AM1.5G illumination conditions (1000 mW/cm²). During testing, the cells were positioned on a vacuum chuck located under the lamp and the chuck temperature was maintained at 25°C +/-1 using a chiller. Both dark and light I-V curves were collected by sweeping voltage between -0.2V and +1.2V and measuring current. Standard solar cell electrical parameters were collected from the instrument including Cell efficiency (%), Series resistance (Rs), Shunt Resistance (Rsh) and Open Circuit Voltage (Voc), short-circuit current (Isc), and short-circuit current density (Jsc). The Cell efficiency η is a key parameter in evaluating the performance of a solar cell. The fill factor is defined as the ratio of the maximum power from the solar cell to the product of Voc and Isc. Graphically, the fill factor is the division of the area of the largest rectangle which could fit between the I-V curve and I/V axes by Isc^{∗}Voc. The results were obtained using standard computer software available in the industry for measuring electrical parameters of solar cells.

### Inventive Examples A-D; Reference Examples E-F; Comparative Example G

An example of a control paste (Comparative Example G) is the formulation in Table 2 with no bismuth additive. The Example pastes A-F in Table 3 contain 0.2% Bi₂O₃ added to the Table 2 formulations with different particle sizes. The pastes were mixed with the DAC mixer vigorously and are designated as the final pastes used in this experiment.

**Table 3. Comparison among different particle sizes of Bi₂O₃**

| **Paste** | **Bi₂O₃** | **Average Particle Size*** | **Efficiency** |
|---|---|---|---|
| A | Bi₂O₃ - 1 | **38nm** | 17.8% |
| B | Bi₂O₃ - 2 | **∼140nm** | 17.7% |
| C | Bi₂O₃ - 3 | **∼300nm** | 15.9% |
| D | Bi₂O₃ - 4 | **∼300nm** | 16.0% |
| E | Bi₂O₃ - 5 | **∼3um** | 10.7% |
| F | Bi₂O₃ - 6 | **∼20um** | 3.7% |
| G | without Bi₂O₃ additive | | 6.2% |
| ***average particle size is based on manufacturer's specifications** | | | |

Table 1 shows that 1) the Si solar cells efficiency is 6.2% without the Bi₂O₃ additive in the paste and that after adding Bi₂O₃, the greatest efficiency achieved is 17.8%; 2) the solar cell's efficiency is dramatically altered with different Bi₂O₃ particle size added into the Ag paste; 3) in general the smaller particle size the better efficiency. In Example F, the relatively large particle size detracts from the efficiency and thus this would not be a preferred material.

### Inventive Example B; Comparative Examples 1-4

The same procedure described above in the Inventive Examples A-G for making a paste is used for making the Example 1-4 pastes. Examples 1-4 were prepared by adding the molar concentration equivalent of bismuth additives as shown in Table 4 into the formulation shown in Table 2. These new materials are Bi contained inorganic compounds. 6 inch multi-crystalline wafer with emitter sheet resistance of 75 to 85 Ohm/square are used in this test. Solar cell fabrication and test performance for pastes are similar to those processes described for example A-G. This controlled experiment clearly shows the role played by pure Bi₂O₃ with the right particle size. The purity is preferably >98%, preferably >99.9%. The right Bi source in the paste can help form a good contact between n-Si layer and Ag, thus a lower series resistance Rs, in turn a significantly higher efficiency.

Table 4 shows that Example B, which is based on Bi₂O₃-2 (see Table 3) of average particle size of 140nm, imparts far better efficiency and much reduced resistance in comparison with other bismuth additives.

**Table 4. Comparison among different Bi additives**

| | **Chemical** | | **Electrical Performance** | | | | |
|---|---|---|---|---|---|---|---|
| **Paste** | structure | chemical name | Efficiency (%) | Rs (Ohm^{∗}cm2) | Voc (mV) | Jsc (mA/cm2) | F.F. (%) |
| **1** | Bi₂S₃ | Bismuth(III) sulfide | 2.00 | - | 620.4 | 13.8 | 23.9 |
| **2** | Bi₂Te₃ | Bismuth(III) telluride | 8.51 | 9.91 | 624.8 | 33.7 | 40.1 |
| **3** | Bi₂Se₃ | Bismuth(III) selenide | 8.23 | 9.55 | 624.2 | 33.4 | 38.9 |
| **4** | BiPO₄ | Bismuth(III) phosphate | 4.04 | - | 622.9 | 22.8 | 27.6 |
| **B (see Table 3)** | Bi₂O₃-2 in Table 3 | Bismuth(III) Oxide | 17.70 | 1.21 | 632.1 | 36.7 | 76.4 |

## Claims

1. A composition for silicon solar cells comprising
a) Ag powder,
b) glass frits,
c) at least one organic resin,
d) at least one solvent,
e) and between 0.1-1.5 wt% of a Bi₂O₃ additive wherein the Bi₂O₃ has an average particle size of between 20 to 300 nm and wherein the additive contains greater than 99.0 wt% Bi₂O₃.

2. A composition according to claim 1 further comprising an adhesion promoting agent, a thixotropic agent and/or a dispersant.

3. A composition according to any one of the preceding claims wherein the Bi₂O₃ additive contains no other metal oxide.

4. A composition according to any one of the preceding claims comprising between 0.15 to 0.3 wt% Bi₂O₃ additive.

5. A composition according to any one of the preceding claims comprising between 75 to 95 wt% of Ag powder, optionally comprising between 80 to 92 wt% of Ag powder.

6. A composition according to any one of the preceding claims wherein the Ag powder has a particle size D50 between 0.1 to 5µm, optionally wherein the Ag powder has a particle size D50 between 0.5 to 2 µm.

7. A composition according to any one of the preceding claims comprising between 0.5 to 10 wt% of glass frits, optionally comprising 1 to 5 wt% of glass frits.

8. A composition according to any one of the preceding claims wherein the glass frits are formed from PbO, Al₂O₃, SiO₂, B₂O₃, Li₂O, TiO₂, ZnO, P₂O₅, V₂O₅, SrO, CaO, Sb₂O₃, SO₂, As₂O₃, Bi₂O₃, Tl₂O₃, Ga₂O₃, MgO, Y₂O₃, ZrO₂, Mn₂O₅, CoO, NiO, CuO, SrO, Mo₂O₃, RuO₂, TeO₂, CdO, In₂O₃, SnO₂, La₂O₃, BaO and mixtures thereof.

9. A composition according to any one of the preceding claims comprising between 0.2 to 2 wt% of organic resin, optionally comprising between 0.5 to 1.5 wt% of organic resin.

10. A composition according to any one of the preceding claims wherein the resin is selected from acrylic resin, epoxy resin, phenol resin, alkyd resin, cellulose polymers, polyvinyl alcohol, rosin and mixtures thereof.

11. A composition according to any one of the preceding claims comprising between 2 to 20 wt% of solvent.

12. A composition according to any one of the preceding claims comprising between 2 to 8 wt% of solvent.

13. A composition according to any one of the preceding claims wherein the solvent is selected from texanol, propanol, isopropyl alcohol, ethylene glycol and diethylene glycol derivatives, toluene, xylene, dibutyl carbitol, terpineol and mixtures thereof.

14. A composition according to any one of the preceding claims comprising between 0.1 to 0.7 wt% of an adhesion-promoting agent.

15. A composition according to any one of the preceding claims comprising between 0.01 to 2.0 wt% of a dispersant.

16. A composition according to any one of the preceding claims comprising between 0.5 to 2.0 wt% of a thixotropic agent.

17. A composition according to any one of the preceding claims wherein the composition is in the form of a paste.

18. A solar cell comprising a silicon wafer and a composition according to anyone of the preceding claims on the front side surface of the silicon wafer.

19. A solar cell according to claim 18 wherein the silicon wafer has two overlapping layers, one comprising A1 and one comprising Ag, on the back side surface of the silicon wafer.

20. A process for making a solar cell comprising applying a coating of the composition according to anyone of claims 1 to 17 onto the front side surface of a silicon wafer and firing the silicon coated wafer.

21. A process according to claim 20 further comprising applying two overlapping layers one comprising A1 and one comprising Ag to the back side surface of the silicon wafer.

## Patentansprüche

1. Zusammensetzung für Silicium-Solarzellen, umfassend
a) Ag-Pulver,
b) Glasfritten,
c) mindestens ein organisches Harz,
d) mindestens ein Lösungsmittel,
e) und zwischen 0,1-1,5 Gew.-% eines Bi₂O₃-Additivs, wobei das Bi₂O₃ eine mittlere Teilchengröße zwischen 20 bis 300 nm aufweist und wobei das Additiv mehr als 99,0 Gew.-% Bi₂O₃ enthält.

2. Zusammensetzung nach Anspruch 1, ferner umfassend einen Haftvermittler, ein Thixotropiermittel und/oder ein Dispergiermittel.

3. Zusammensetzung nach einem der vorhergehenden Ansprüche, wobei das Bi₂O₃-Additiv kein anderes Metalloxid enthält.

4. Zusammensetzung nach einem der vorhergehenden Ansprüche, umfassend zwischen 0,15 bis 0,3 Gew.-% Bi₂CO₃ -Additiv.

5. Zusammensetzung nach einem der vorhergehenden Ansprüche, umfassend zwischen 75 bis 95 Gew.-% Ag-Pulver, gegebenenfalls umfassend zwischen 80 bis 92 Gew.-% Ag-Pulver.

6. Zusammensetzung nach einem der vorhergehenden Ansprüche, wobei das Ag-Pulver eine Teilchengröße D50 zwischen 0,1 bis 5 µm aufweist, gegebenenfalls wobei das Ag-Pulver eine Teilchengröße D50 zwischen 0,5 bis 2 µm aufweist.

7. Zusammensetzung nach einem der vorhergehenden Ansprüche, umfassend zwischen 0,5 bis 10 Gew.-% Glasfritten, gegebenenfalls umfassend 1 bis 5 Gew.-% Glasfritten.

8. Zusammensetzung nach einem der vorhergehenden Ansprüche, wobei die Glasfritten aus PbO, Al₂O₃, SiO₂, B₂O₃, Li₂O, TiO₂, ZnO, P₂O₅, V₂O₅, SrO, CaO, Sb₂O₃, SO₂, As₂O₃, Bi₂O₃, Tl₂O₃, Ga₂O₃, MgO, Y₂O₃, ZrO₂, Mn₂O₅, CoO, NiO, CuO, SrO, Mo₂O₃, RuO₂, TeO₂, CdO, In₂O₃, SnO₂, La₂O₃, BaO und Mischungen davon gebildet sind.

9. Zusammensetzung nach einem der vorhergehenden Ansprüche, umfassend zwischen 0,2 bis 2 Gew.-% organisches Harz, gegebenenfalls umfassend zwischen 0,5 bis 1,5 Gew.-% organisches Harz.

10. Zusammensetzung nach einem der vorhergehenden Ansprüche, wobei das Harz aus Acrylharz, Epoxidharz, Phenolharz, Alkydharz, Cellulosepolymeren, Polyvinylalkohol, Kolophonium und Mischungen davon ausgewählt ist.

11. Zusammensetzung nach einem der vorhergehenden Ansprüche, umfassend zwischen 2 bis 20 Gew.-% Lösungsmittel.

12. Zusammensetzung nach einem der vorhergehenden Ansprüche, umfassend 2 bis 8 Gew.-% Lösungsmittel.

13. Zusammensetzung nach einem der vorhergehenden Ansprüche, wobei das Lösungsmittel aus Texanol, Propanol, Isopropylalkohol, Ethylenglykol- und Diethylenglykolderivaten, Toluol, Xylol, Dibutylcarbitol, Terpineol und Mischungen davon ausgewählt ist.

14. Zusammensetzung nach einem der vorhergehenden Ansprüche, umfassend zwischen 0,1 bis 0,7 Gew.-% eines Haftvermittlers.

15. Zusammensetzung nach einem der vorhergehenden Ansprüche, umfassend zwischen 0,01 bis 2,0 Gew.-% eines Dispergiermittels.

16. Zusammensetzung nach einem der vorhergehenden Ansprüche, umfassend zwischen 0,5 bis 2,0 Gew.-% eines Thixotropiermittels.

17. Zusammensetzung nach einem der vorhergehenden Ansprüche, wobei die Zusammensetzung in Form einer Paste vorliegt.

18. Solarzelle, umfassend einen Silicium-Wafer und eine Zusammensetzung nach einem der vorhergehenden Ansprüche auf der vorderseitigen Oberfläche des Silicium-Wafers.

19. Solarzelle nach Anspruch 18, wobei der Silicium-Wafer auf der rückseitigen Oberfläche des Silicium-Wafers zwei überlappende Schichten, von denen eine Al umfasst und eine Ag umfasst, aufweist.

20. Verfahren zur Herstellung einer Solarzelle, bei dem man eine Beschichtung aus der Zusammensetzung nach einem der Ansprüche 1 bis 17 auf die vorderseitige Oberfläche eines Silicium-Wafers aufbringt und den beschichteten Silicium-Wafer brennt.

21. Verfahren nach Anspruch 20, bei dem man ferner auf die rückseitige Oberfläche des Silicium-Wafers zwei überlappende Schichten, von denen eine Al umfasst und eine Ag umfasst, aufbringt.

## Revendications

1. Composition pour des cellules solaires au silicium comprenant
a) de la poudre d'Ag,
b) des frittes de verre,
c) au moins une résine organique,
d) au moins un solvant
e) et entre 0,1-1,5 % en poids d'un additif à base de Bi₂O₃, le Bi₂O₃ possédant une grosseur moyenne de particule se situant entre 20 et 300 nm et l'additif contenant plus de 99,0 % en poids de Bi₂O₃.

2. Composition selon la revendication 1, comprenant en outre un agent favorisant l'adhésion, un agent thixotrope et/ou un dispersant.

3. Composition selon l'une quelconque des revendications précédentes, l'additif à base de Bi₂O₃ ne contenant pas d'autre oxyde métallique.

4. Composition selon l'une quelconque des revendications précédentes comprenant entre 0,15 et 0,3 % en poids d'additif à base de Bi₂O₃.

5. Composition selon l'une quelconque des revendications précédentes comprenant entre 75 et 95 % en poids de poudre d'Ag, éventuellement comprenant entre 80 et 92 % en poids de poudre d'Ag.

6. Composition selon l'une quelconque des revendications précédentes, la poudre d'Ag possédant une grosseur de particule D50 se situant entre 0,1 et 5 µm, éventuellement la poudre d'Ag possédant une grosseur de particule D50 se situant entre 0,5 et 2 µm.

7. Composition selon l'une quelconque des revendications précédentes comprenant entre 0,5 et 10 % en poids de frittes de verre, éventuellement comprenant entre 1 et 5 % en poids de frittes de verre.

8. Composition selon l'une quelconque des revendications précédentes, les frittes de verre étant formées de PbO, d'Al₂O₃, de SiO₂, de B₂O₃, de Li₂O, de TiO₂, de ZnO, de P₂O₅, de V₂O₅, de SrO, de CaO, de Sb₂O₃, de SO₂, d'As₂O₃, de Bi₂O₃, de Tl₂O₃, de Ga₂O₃, de MgO, d' Y₂O₃, de ZrO₂, de Mn₂O₅, de CoO, de NiO, de CuO, de SrO, de Mo₂O₃, de RuO₂, de TeO₂, de CdO, de In₂O₃, de SnO₂, de La₂O₃, de BaO et de mélanges correspondants.

9. Composition selon l'une quelconque des revendications précédentes comprenant entre 0,2 et 2 % en poids de résine organique, éventuellement comprenant entre 0,5 et 1,5 % en poids de résine organique.

10. Composition selon l'une quelconque des revendications précédentes, la résine étant choisie parmi la résine acrylique, la résine époxy, la résine phénolique, la résine alkyde, les polymères de cellulose, le poly(alcool vinylique), la rosine et les mélanges correspondants.

11. Composition selon l'une quelconque des revendications précédentes comprenant entre 2 et 20 % en poids de solvant.

12. Composition selon l'une quelconque des revendications précédentes comprenant entre 2 et 8 % en poids de solvant.

13. Composition selon l'une quelconque des revendications précédentes, le solvant étant choisi parmi le texanol, le propanol, l'alcool isopropylique, l'éthylèneglycol et les dérivés de diéthylèneglycol, le toluène, le xylène, le dibutyl carbitol, le terpinéol et les mélanges correspondants.

14. Composition selon l'une quelconque des revendications précédentes comprenant entre 0,1 et 0,7 % en poids d'un agent favorisant l'adhésion.

15. Composition selon l'une quelconque des revendications précédentes comprenant entre 0,01 et 2,0 % en poids d'un dispersant.

16. Composition selon l'une quelconque des revendications précédentes comprenant entre 0,5 et 2,0 % en poids d'un agent thixotrope.

17. Composition selon l'une quelconque des revendications précédentes, la composition se trouvant sous forme d'une pâte.

18. Cellule solaire comprenant une plaquette de silicium et une composition selon l'une quelconque des revendications précédentes sur la surface avant de la plaquette de silicium.

19. Cellule solaire selon la revendication 18, la plaquette de silicium possédant deux couches qui se chevauchent, l'une comprenant Al et l'autre comprenant Ag, sur la surface arrière de la plaquette de silicium.

20. Procédé pour la fabrication d'une cellule solaire comprenant l'application d'un revêtement de la composition selon l'une quelconque des revendications 1 à 17 sur la surface avant d'une plaquette de silicium et la cuisson de la plaquette de silicium revêtue.

21. Procédé selon la revendication 20 comprenant en outre l'application de deux couches qui se chevauchent, l'une comprenant Al et l'autre comprenant Ag sur la surface arrière de la plaquette de silicium.
